**Europäisches Patentamt**

**European Patent Office**

(19) **Office européen des brevets**

(11) Numéro de publication : **0 313 452 B1**

(12) # FASCICULE DE BREVET EUROPEEN

(45) Date de publication du fascicule du brevet :
18.09.91 Bulletin 91/38

(51) Int. Cl.⁵ : **H01L 21/285, C23C 16/42**

(21) Numéro de dépôt : **88402620.4**

(22) Date de dépôt : **18.10.88**

(54) **Procédé de dépot de siliciure de métal réfractaire pour la fabrication de circuits intégrés.**

(30) Priorité : **19.10.87 FR 8714383**

(43) Date de publication de la demande :
**26.04.89 Bulletin 89/17**

(45) Mention de la délivrance du brevet :
**18.09.91 Bulletin 91/38**

(84) Etats contractants désignés :
**AT BE CH DE ES FR GB IT LI NL SE**

(56) Documents cités :
**EP-A- 0 077 535
EP-A- 0 157 052
GB-A- 2 148 946
JOURNAL OF MATERIALS SCIENCE, vol. 22,
no. 2, février 1987, pages 547-553, Londres,
GB; S.MOTOJIMA et al.: "PREPARATION AND
PROPERTIES OF NICKEL SILICIDE LAYERS
BY THE DIFFUSION AND CVD processes
using Si2C16 as a source of silicon".**

(72) Inventeur : **Hirase, Ikuo**
**75, quai d'Orsay**
**F-75321 Paris cedex 07 (FR)**
Inventeur : **Rufin, Denis**
**75, quai d'Orsay**
**F-75321 Paris cedex 07 (FR)**
Inventeur : **Sumiya, Tooru**
**2500 Hagisono**
**Chigasaki 253 (JP)**
Inventeur : **Matsuura, Masamichi**
**2500 Hagisono**
**Chigasaki 253 (JP)**
Inventeur : **Schack, Michael**
**75, quai d'Orsay**
**F-75321 Paris cedex 07 (FR)**
Inventeur : **Ukishima, Sadayuki**
**2500 Hagisono**
**Chigasaki 253 (JP)**

(74) Mandataire : **Vesin, Jacques et al**
**L'AIR LIQUIDE, SOCIETE ANONYME POUR
L'ETUDE ET L'EXPLOITATION DES
PROCEDES GEORGES CLAUDE 75, quai
d'Orsay**
**F-75321 Paris Cédex 07 (FR)**

(73) Titulaire : **L'AIR LIQUIDE, SOCIETE ANONYME
POUR L'ETUDE ET L'EXPLOITATION DES
PROCEDES GEORGES CLAUDE
75, Quai d'Orsay
F-75321 Paris Cédex 07 (FR)**

## Description

La présente invention concerne un procédé de dépôt de siliciure de métal réfractaire par la technique de dépôt chimique en phase vapeur pour la fabrication de circuits intégrés.

Dans la fabrication de circuits intégrés, pour réaliser des interconnections en particulier, il est nécessaire de pouvoir déposer du silicium polycristallin, ou des métaux réfractaires, meilleurs conducteurs, ou encore des composés intermédiaires du type $WSi_x$, par exemple, c'est à dire des siliciures de métal réfractaire.

Classiquement, on réalise la réaction :

$$WF_6 + 2\ SiH_4 \rightarrow WSi_2 + 6\ HF + H_2$$

qui peut produire $WSi_2$ à partir de précurseurs classiques de W et du Si. Une telle réaction est par exemple décrite dans EP-A-0157052. D'une part, cette technique présente le désavantage de produire HF en grande quantité ce qui est néfaste tant pour les pompes que pour $SiO_2$. D'autre part, la demanderesse a mis en évidence que $WF_6$, en présence de $SiF_4$, peut ne donner aucun dépôt dans des conditions usuelles.

Le problème du dépôt de siliciures de métaux réfractaires à partir de précurseurs fluorés essentiellement est résolu selon l'invention. En effet, le procédé de dépôt selon l'invention est caractérisé en ce que le précurseur de métal réfractaire est mélangé sous forme gazeuse à des sous-fluorures de silicium juste avant le dépôt.

Ce procédé permet des dépôts particulièrement non sélectifs et conformes. Les exemples et la description ci-dessous concernent des dépôts de $WSi_x$ en particulier, mais d'autres métaux réfractaires sont cependant envisageables, comme Mo et Ti. Dans le cas du tungstène, selon l'invention, on utilise de préférence comme précurseur du $WF_6$.

D'autres caractéristiques et avantages de l'invention apparaitront dans la description détaillée ci-après et sur les dessins annexés qui représentent :

— à la figure 1, un shéma de réacteur à parois froide en dépression pour la mise en oeuvre du procédé ;

— à la figure 2, un shéma d'un four tubulaire pour produire des sous-fluorures ;

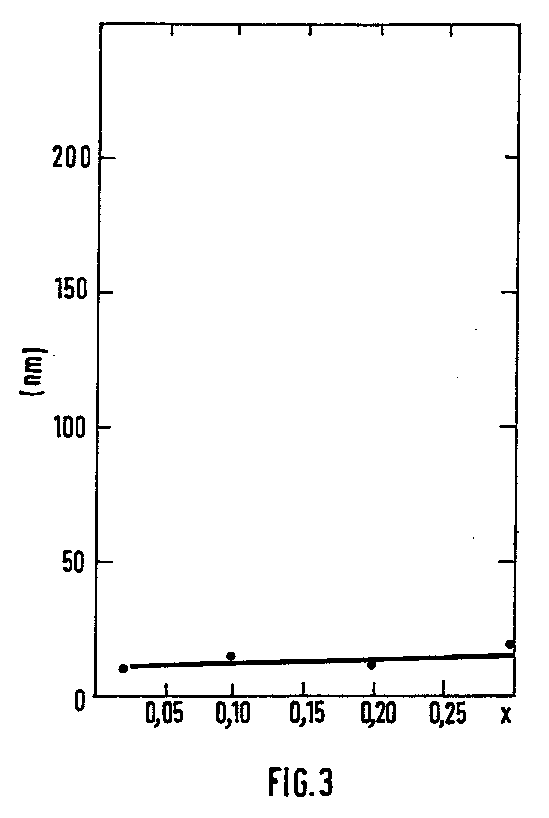

— aux figures 3 à 7, des courbes présentant les résultats de dépôts réalisés comme cela sera décrit ci après.

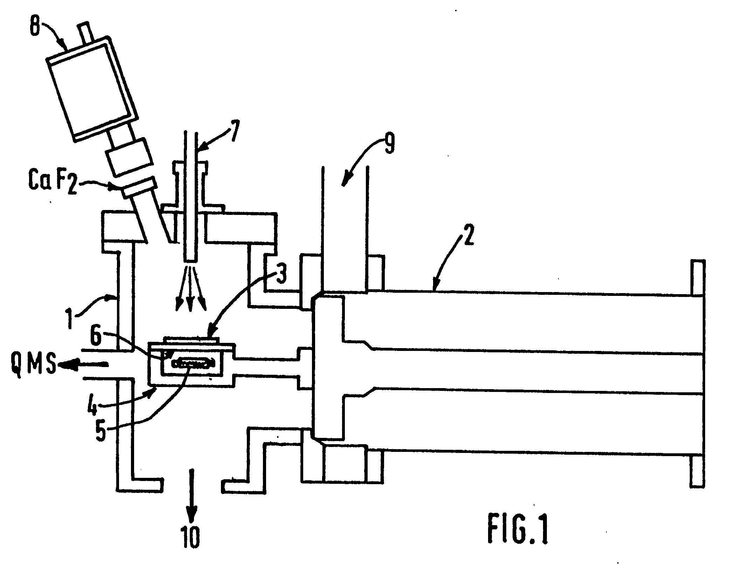

Sur la figure 1 apparait un four de dépôt comportant une chambre étanche 1, une phase vapeur (CVD), munis de moyens 10 de mise en dépression non représentés et de moyens d'analyse des gaz (QMS), et une chambre de chargement 2 avec une vanne 9 permettent d'isoler les tranches de silicium (Wafers) avant leur chargement et d'éviter leur contamination. Une tranche 3 est disposée dans la chambre de réaction étanche 1 sur un support 4 comportant une lampe à halogène 5, qui permet de chauffer la tranche 3 au travers d'une plaque de quartz 6. Les gaz précurseurs et vecteurs sont introduits au dessus de la tranche traitée 3 par une buse 7. Les températures sont mesurées à l'aide d'un thermomètre à infrarouge 8.

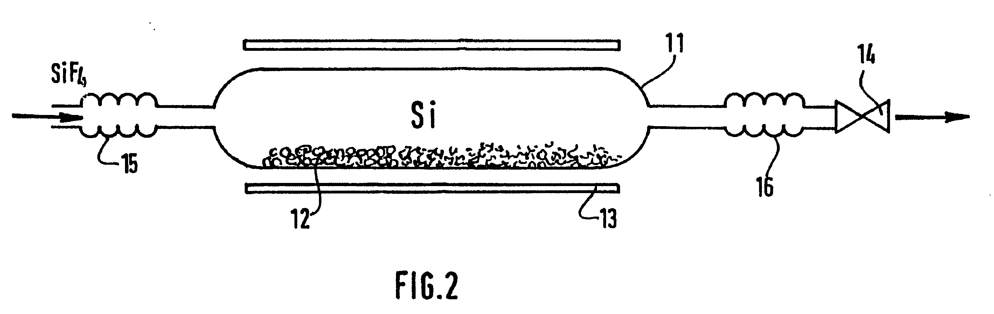

A la figure 2 apparait un four tubulaire de fabrication des sous-fluorures.

La charge de $SiF_4$ passe dans le four 11 chargé en morceaux de silicium. Le four 11 est chauffé par des résistances électriques capables de porter le Si à environ 1200 à 1500K. Une vanne 14 permet d'isoler le four 11 du dispositif de CVD, (en aval de la vanne 14). Des flexibles 15, 16 relient le four d'une part à la source de $SiF_4$ (non représentée) et à la vanne 14.

Les espèces $SiF_2$ et $SiF_3$ sont générés par passage de $SiF_4$ sur des morceaux de Si chauffés à 1 400 K, comme le montre la figure 2. Dans ces conditions de température, le mélange de fluorure et sous-fluorures comporte environ 51% de $SiF_3$, 46% de $SiF_4$ et 3% de $SiF_2$.

Ce mélange des précursseurs de W, $WF_6$ et de silicium, les sous-fluorures de silicium réagissent selon la réaction :

$$aWF_6 + bSiF_3 + cSiF_2 \rightarrow gWSi_x + hSiF_4$$

où a, b, c, g et h sont des paramètres thermodynamiques.

La figure 3 montre qu'aucun dépôt n'est réalisé (épaisseur du dépôt (mm) en fonction du rapport des débits $WF_6$ / $SF_4$) quand on met en présence $WF_6$ et $SF_4$, après une durée de dépôt de 7 mn et pour une température de tranche de silicium de 400°C.

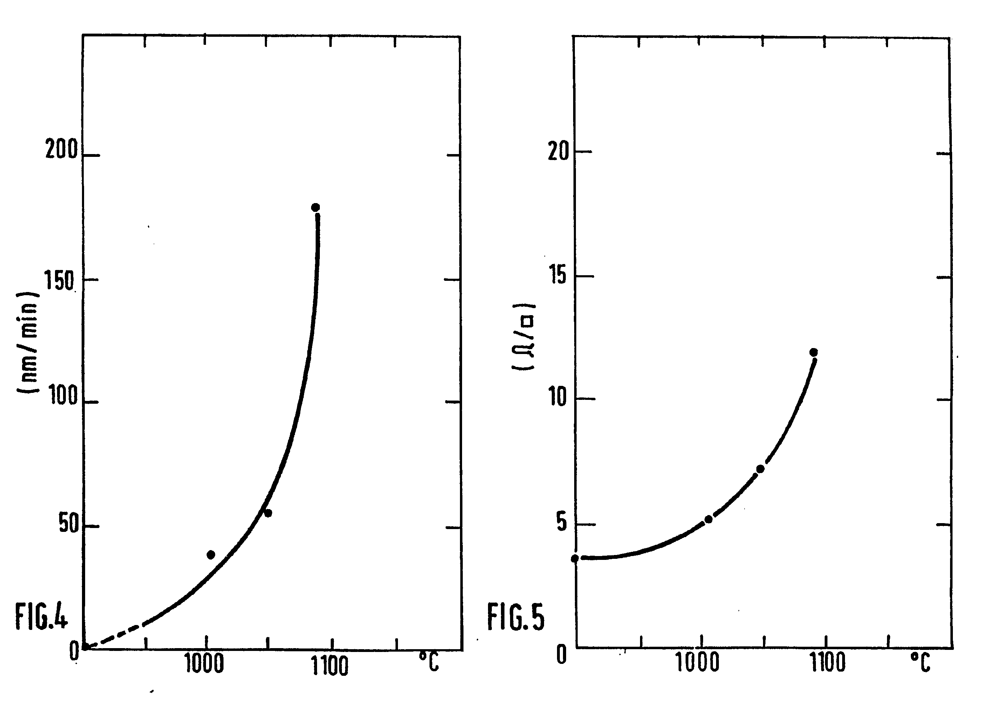

Les figures 4 et 5 représentent respectivement la vitessse de dépôt (nm/min) et la résistivité du dépôt réalisé pour diverses températures du four à $SiF_4$. Le rapport de débit $WF_6/SiF_4$ est de 1/50, la pression de l'ordre de 0,472-0,482 Torr, et la température de la tranche de 350°C.

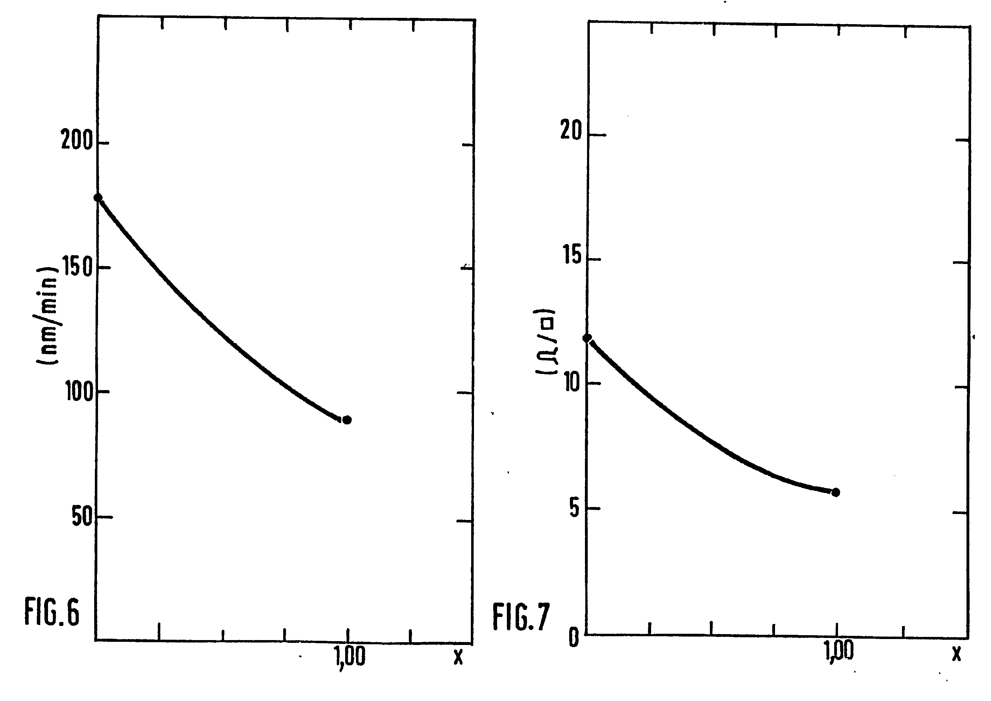

Dans un mode de réalisation particulier, on peut mélanger aux précurseurs et gaz vecteurs classiquement utilisés (Ar et He) de l'hydrogène ; un dépôt a lieu, pour une température de four à Si de 1090°C, une température de tranche de silicium de 350°C et une durée de dépôt de 5 mm, les figures 6 et 7 représentent respectivement la vitesse de dépôt et la résistivité de la couche déposée en fonction du rapport x des débits $H_2/SiF_4$.

## Revendications

1. Procédé de dépôt de siliciure de métal réfractaire par la technique de dépôt chimique en phase vapeur à partir de précurseur de métal et du précurseur de silicium pour la fabrication de circuits intégrés, caractérisé en ce que le précurseur de métal réfractaire est mélangé sous forme gazeuse à des sous-fluorures de silicium juste avant le dépôt.

2. Procédé selon la revendication 1, caractérisé en ce que le métal réfractaire est choisi parmi W, Ti et Mo.

3. Procédé selon la revendication 2 ou 3, caractérisé en ce que le précurseur de W est WF$_6$.

4. Procédé selon l'une des revendications 1 à 3, caractérisé en ce que le sous-fluorures de silicium sont générés en ligne avant leur mélange au précurseur de métal par passage de SiF$_4$ sur des morceaux de silicium chauffé.

5. Procédé selon la revendication 4, caractérisé en ce que le silicium est chauffé dans un four tubulaire porté à environ 1200 à 1500 K.

6. Procédé selon l'une des revendications 1 à 5, caractérisé en ce que les tranches de silicium peuvent être chauffés dans le réacteur de dépôt, à travers une vitre en quartz.

7. Procédé selon l'une des revendications 1 à 6, caractérisé en ce que le dépôt est réalisé dans un réacteur à parois froides en dépression.

8. Procédé selon l'une des revendications 1 à 7, caractérisé en ce que les précursseurs sont entrainés par des gaz vecteurs choisis parmi Ar, He et H$_2$.

## Patentansprüche

1. Verfahren zum Abscheiden von hochschmelzendem Metallsilizid über eine chemische Gasphasenabscheidung, ausgehend von einem Vorläufer des Metalls und einem Vorläufer des Siliziums, zur Herstellung von integrierten Schaltungen, dadurch **gekennzeichnet**, dass der Vorläufer des hochschmelzenden Metalls in Gasform mit Subfluoriden des Siliziums direkt vor der Abscheidung vermengt wird.

2. Verfahren nach Anspruch 1, dadurch **gekennzeichnet**, dass das hochschmelzende Metall aus W, Ti und Mo ausgewählt wird.

3. Verfahren nach Anspruch 1 oder 2, dadurch **gekennzeichnet**, dass der Vorläufer des Wolframs WF$_6$ ist.

4. Verfahren nach einem der Ansprüche 1 bis 3, dadurch **gekennzeichnet**, dass die Subfluoride des Siliziums direkt vor dem Vermengen mit dem Vorläufer des Metalls durch Überleiten von SiF$_4$ über erhitzte Siliziumstücke erzeugt werden.

5. Verfahren nach Anspruch 4, dadurch **gekennzeichnet**, dass das Silizium in einem Röhrenofen bei etwa 1200 bis 1500°K erhitzt wird.

6. Verfahren nach einem der Ansprüche 1 bis 5, dadurch **gekennzeichnet**, dass Siliziumscheiben im Abscheidungsreaktor über einer Quarzglasscheibe erhitzt werden.

7. Verfahren gemäss einem der Ansprüche 1 bis 6, dadurch **gekennzeichnet**, dass die Abscheidung in einem kaltwandigen Reaktor bei Unterdruck durchgeführt wird.

8. Verfahren gemäss einem der Ansprüche 1 bis 7, dadurch **gekennzeichnet**, dass die Vorläufer mittels Gasträgern, die aus Ar, He und H$_2$ ausgewählt sind, eingeführt werden.

## Claims

1. Process for depositing refractory metal silicides by vapor phase chemical deposition from a metal precursor and a silicon precursor for the manufacture of integrated circuits, characterized in that the refractory precursor is mixed in gaseous form with silicon sub-fluorides immediately before the deposition.

2. Process according to claim 1, characterized in that the refractory metal is selected among W, Ti and Mo.

3. Process according to claim 2 or 3, characterized in that the precursor of W is WF$_6$.

4. Process according to one of claims 1 to 3, characterized in that the silicon sub-fluorides are produced in line before being mixed with the metal precursor by passing SiF$_4$ on pieces of heated silicon.

5. Process according to claim 4, characterized in that the silicon is heated in a tubular oven heated to about 1200 to 1500 K.

6. Process according to one of claims 1 to 5, characterized in that the silicon wafers may be heated in the deposition reactor, through a quartz glass.

7. Process according to one of claims 1 to 6, characterized in that the deposition is carried out in a reactor with cold walls maintained under partial vacuum.

8. Process according to one of claims 1 to 7, characterized in that precursors are carried by carrier gases selected among Ar, He and H$_2$.

FIG.1

CaF₂

QMS

FIG.2

SiF₄

Si

EP 0 313 452 B1

FIG.3

FIG.4

FIG.5

EP 0 313 452 B1

FIG.6

FIG.7

EP 0 313 452 B1